# EUROPEAN PATENT SPECIFICATION

(11) **EP 1 012 970 B1**
(45) Date of publication and mention of the grant of the patent: **06.08.2003**
(21) Application number: 99929516.5
(22) Date of filing: 07.07.1999
(51) Int. Cl.: H03J 7/02

(54) **FREQUENCY ADJUSTMENT**
FREQUENZREGELUNG
REGLAGE DE FREQUENCE

(30) Priority: 09.07.1998 GB 9814803
(43) Date of publication of application: 28.06.2000
(73) Proprietor: Pace Micro Technology Ltd, Saltaire, Shipley BD18 3LF (GB)
(72) Inventor: COE, Peter W., Saltaire, Shipley BD18 3LF (GB)
(74) Representative: Wood, Graham
(86) International application number: GB9902031
(87) International publication number: WO00003482

(56) References cited:
- WO-A-92/17010
- US-A- 4 556 988
- US-A- 4 736 456
- US-A- 5 408 196

## Description

The invention which is the subject of this application relates to the ability to adjust and calibrate the frequency adjustable component parts of a piece of apparatus used in the reception and/or handling of signals relating to television broadcast systems and in particular, but not exclusively, to a range of devices such as satellite signal reception devices, terrestrial or radio signal reception devices, cable signal reception devices and in general digital and analogue television signal reception devices and video cassette recorders and hereinafter collectively referred to as set top devices.

In set top devices a number of devices or components are required to be set to operate at specific frequencies or frequency ranges. For example, the set top device is provided with an RF TV modulator which is used by a television set connected to the RF O/P of the set top device to receive signals processed by the set top device. Conventionally, these modulators had relatively poor frequency stability and could tend to drift over time, or be adversely affected by knocks or bumps to the set, variation in temperature and the like. Furthermore, the frequencies were typically factory set and set to a wide range so as to attempt to overcome the problems with the lack of stability. However more recently the RFTV modulators have included phase lock loop VCO design which has enabled the same to be electronically frequency and amplitude adjustable, and for the stability and control of the same to be considerably improved.

In set top devices, there are provided further components which are also required to be set to operate within specific frequency ranges. At the present time, these frequency ranges and/or amplitude levels are factory set so that the set top device manufacturing process includes a time for the setting of the frequency and amplitude of said components. Again the frequency and amplitude to which the components are set can drift over time, due to temperature changes, shock and /or bump and so the components are set to relatively wide frequency ranges in an attempt to reduce the problems that this drift can cause and in some instances can require the set top box being returned to the manufacturer or repair outlet for the frequency settings to be readjusted to enable the set top box to be used. This is undesirable to the customer and indeed to the manufacturer in the time required to initially set and then possible repair the same. A further disadvantage with set top box frequency adjustable components is that the same are manually adjustable and temperature or shock compensation components are included. This again adds to the time of manufacture and expense in labour at least as mechanically adjustable electronic components such as potentiometers which are typically included are required to be potted and the mechanical stability of the same is also a problem.

Attempts have been made to allow the calibration of components in set top devices Document WO9217010 illustrates a system whereby a set box terminal includes a 2^{nd} oscillator and tuner which are frequency set to a particular frequency with reference to a signal broadcast from the head end i.e. the broadcaster location, to a range of set top terminals. This system therefore relies on the broadcast signal from the head end being present and reliable for the frequency setting to be correct. If not then the system will not work.

Documents US5408196 and US4736456 illustrate further known systems. US5408196 relies on a signal held in memory and which signal is referred to over time so that the signal in memory must always be held accurately. The use of the signal is limited to certain components. In US4736456 the system relates to an alignment system for a tuner with reference to an averaged frequency signal value obtained from the mixing of two signals, a fixed frequency signal and local oscillator signal. Thus the signal is dependent on the other system components.

The aim of the present invention is to provide a set top box device which has a means to allow the frequency components of the device to be automatically set to the required frequency or frequency range for operation. It is also a further aim to provide a means whereby, during use the frequency or frequency range of the frequency components is checked and if required adjusted.

In a first aspect of the invention there is provided a set top device for the processing of received digital data for display via a television set connected therewith, said set top device including at least one component which is required to be set to a specific frequency or frequency range for operation and further including an RF TV modulator, said modulator generating a signal of a known frequency and characterised in that the said component is automatically adjustable to the required frequency or frequency range with reference to the RF TV modulator signal which is indicative of the frequency setting of the same.

Typically the RF TV modulator referred to is that which is used in a set top device as a Radio Frequency Television signal generating device.

Typically the RF TV modulator in the set top device incorporates a phase lock loop VCO circuit design and is capable of output signal frequency and amplitude adjustment via control software.

As the frequency of the component or components of the set top signal device is automatically adjusted with reference to an RF modulator, it will be appreciated that the need to manually set the components during manufacture of the set top device is overcome and thus there are considerable time savings achieved in the manufacturing process.

In a second aspect of the invention there is provided a set top device for use with a television set, said set top device including at least one component which is set to operate at a frequency or frequency range and an RF modulator set to operate at a specific frequency or frequency range and characterised in that said RF modulator is operated to generate a reference signal indicative of the frequency setting, said signal referred to by control means for the set top device to set the at least one component to operate at the said frequency or frequency range.

In one preferred embodiment the control means for the set top device refers to the signal from its RF TV modulator at predetermined intervals during use of the set top device and/or on every occasion when the set top device is switched on for use or changes condition. Thus it will be appreciated that in addition to the use of the signal from its RF TV modulator to act as a datum to which the at least one component in the set top device is initially set, the signal can also be used as a reference during use of the set top device. This can allow temperature and shock compensation components which are manually adjustable components currently included in set top devices to be removed as the continued checking of the frequency settings for the component or components of the set top devices ensures that the same do not drift outside acceptable tolerances.

In one preferred embodiment it is envisaged that the control means for the set top device will be set to refer to the signal from the RF TV modulator every time the device is switched on and also on every time a channel change is made to the set top device and/or on every occasion a function change is made to the set top device. The advantage of making the check every time there is a function change is that there will be no alteration to the picture viewed due to the check as this is masked by the function change.

If, upon checking the frequency and/or amplitude of the at least one component, it is found to have changed, then the control means will alter the frequency and/or amplitude setting to bring it back within the predetermined tolerances.

In one preferred embodiment the set top device includes a memory which holds information relating to the results of a predetermined number of previous checks and in one embodiment the control means will compare the current frequency setting of the component with the previous setting rather than the signal from its RF TV modulator and may then only refer to its signal from the RF TV modulator at longer intervals such as once a day, week or the like. The ability to store previous check results may also be used as an indicator to a fault if there is a need to repair the set top device.

The RF TV modulator of the set top device can also be used as a modulated source e.g QPSK/QAM etc and used to calibrate components in a digital set top device and this is another aspect of the invention.

Specific embodiments of the invention will now be described with reference to the accompanying drawings wherein;
Figure 1 illustrates a general diagram of a circuit according to the invention;
Figure 2 illustrates a specific embodiment of the invention; and
Figure 3 illustrates a further embodiment of the invention.

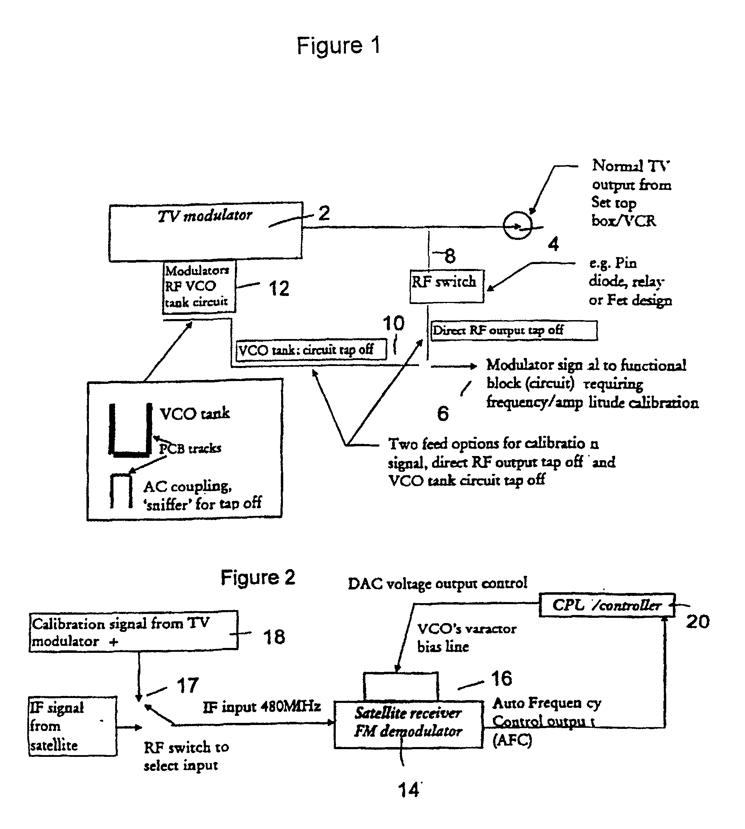

Referring firstly to Figure 1 there is shown a circuit diagram which illustrates the main feature of the invention and comprises a set top device, RF TV modulator 2 with connections to a television set 4. The modulator 2 is used to generate a signal indicative of the frequency setting of the same and said signal can be obtained for use within the set top device to allow the setting of a component or components 6 in the set top device. In the diagram there are shown two ways in which the signal is received and these are by the tap 8 from the TV output or alternatively a tap 10 from the RF VCO circuit 12 of the TV modulator 2.

Figure 2 illustrates a specific example in which the FM demodulator 14 of the satellite receiver set top device 16 is required to be frequency set and/or subsequently checked during operation. In the first instance and at spaced intervals thereafter the connection 17 to the TV Modulator 18 can be completed upon a signal from the control means 20 for the set top device and, when complete, a signal from the TV modulator is received. This signal is indicative of the frequency setting and the FM demodulator of the satellite receiver is set to operate at the required frequency accordingly. In between references to the signal from the TV modulator, the frequency of the FM demodulator can be checked with reference to a memory with the set top device and the control means 20 is used to refer the current frequency setting with the previous setting or an average of the previous settings and adjust the current setting if required. Thus it will be appreciated that the references to the television modulator signal may be less frequent than the number of checks on the frequency setting of the set top box component or components.

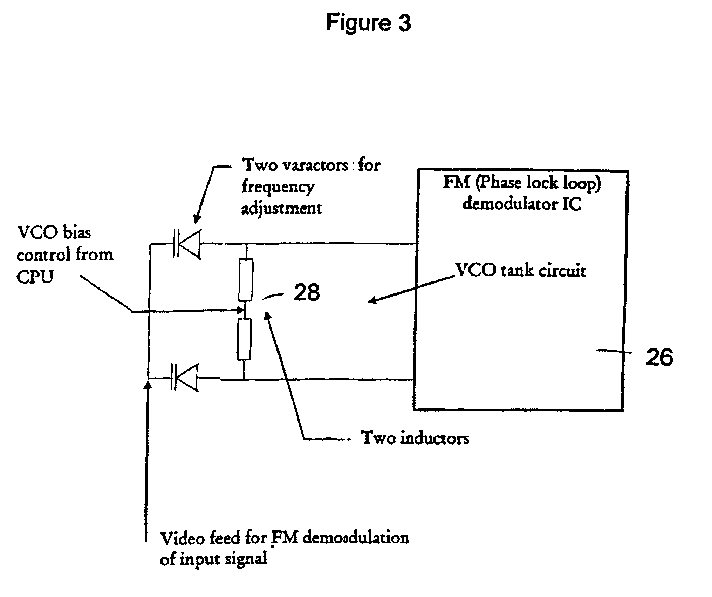

A further feature of the invention is shown in Figure 3 wherein there is shown a set top device with an FM demodulator IC 26 connected to a bias control 28 from the control means and a video feed for FM modulation of the input signal. As it is possible to alter the voltage bias point of the FM modulators VCO varactors this alters the nominal tuned centre frequency of the VCO. Thus it is possible to realign a VCO that has drifted off the required centre frequency by adjusting the centre frequency in response to monitoring of the AFC condition, which is typically a voltage level indicating frequency difference between the VCO centre frequency and that of the IF input frequency, and adjusting the VCO varactor bias voltage until a required(zero point) voltage is set on the AFC output.

Thus it will be appreciated that the apparatus and method according to the present invention represents considerable advantages to the consumer and user of the set top devices described as it allows the operating parameters of the same to be maintained within the specified and optimum tolerances and, furthermore offers savings to the manufacturers of the set top boxes in terms of reduction of labour time in the manufacture of the same due to the ability to auto set the components rather than manually set, a reduction in the additional mechanical components required to be included in the set top devices and a reduction in the repairs necessary to set top devices.

## Claims

1. A set top device (16) for the processing of received digital data for display via a television set (4) connected therewith, said set top device including at least one component (6; 14) which is required to be set to a specific frequency or frequency range for operation and further including an RF TV modulator (2; 18), said modulator generating a signal at a known frequency and **characterised in that** the said component is automatically adjustable to the required specific frequency or frequency range with reference to the RF TV modulator signal which is indicative of the frequency setting of the same.

2. A set top device according to claim 1 **characterised in that** the RF TV modulator is used in the set top device as a radio frequency television signal generating device.

3. A set top device according to claim 2 **characterised in that** the RF TV modulator incorporates a phase lock loop VCO circuit (12) and is capable of output signal frequency and amplitude adjustment.

4. A set top device according to claim 3 **characterised in that** the output signal frequency and amplitude adjustment is performed via control software or processing system (20) within the set top device.

5. A set top device (16) for use with a television set (4), said set top device including at least one component (6; 14) which is set to operate at a frequency or frequency range and an RF TV modulator (2; 18) set to operate at a specific frequency or frequency range and **characterised in that** said RF TV modulator is operated to generate a reference signal indicative of the frequency setting, said signal referred to by control means (20) for the set top device to set the at least one component to operate at the said frequency or frequency range.

6. A set top device according to claim 5 **characterised in that** the control means (20) refers to a signal from the RF TV modulator at intervals of time.

7. A set top device according to claim 6 **characterised in that** reference is made to the RF TV modulator at predetermined time intervals during use of the set top device.

8. A set top device according to claim 6 **characterised in that** reference is made to the RF TV modulator upon a change in function or channel of the set top box.

9. A set top device according to any preceding claim **characterised in that** the same includes a memory in which information relating to the results of a predetermined number of previous references to the RF TV modulator reference signal are stored.

10. A set top device according to claim 9 **characterised in that** reference is made to the results held in the memory at intervals of time in addition to or instead of reference to the RF TV modulator signal.

11. A set top device according to claim 5 **characterised in that** the RF TV modulator is used as a modulated source to calibrate the at least one component included in the set top device for the receipt and processing of digital data.

12. A set top box device according to claim 11 **characterised in that** the RF TV modulator is used as a QPSK/QAM modulator device.

## Patentansprüche

1. Aufsatzgerät (16) zur Verarbeitung empfangener digitaler Daten zur Anzeige auf einem daran angeschlossenen Fernsehapparat (4), wobei das genannte Aufsatzgerät wenigstens eine Komponente (6; 14) beinhaltet, die aufeine(n) bestimmte(n) Frequenz oder Frequenzbereich für den Betrieb eingestellt werden muss, und ferner mit einem HF-TV-Modulator (2; 18), wobei der genannte Modulator ein Signal mit einer bekannten Frequenz erzeugt, **dadurch gekennzeichnet, dass** die genannte Komponente automatisch auf die/den benötigte(n) bestimmte(n) Frequenz oder Frequenzbereich mit Bezug auf das HF-TV-Modulatorsignal eingestellt werden kann, das die Frequenzeinstellung desselben anzeigt.

2. Aufsatzgerät nach Anspruch 1, **dadurch gekennzeichnet, dass** der HF-TV-Modulator in dem Aufsatzgerät als Gerät zum Erzeugen eines Funkfrequenz-Fernsehsignals verwendet wird.

3. Aufsatzgerät nach Anspruch 2, **dadurch gekennzeichnet, dass** der HF-TV-Modulator eine Phasenregelkreis-VCO-Schaltung (12) beinhaltet und Frequenz und Amplitude des Ausgangssignals einstellen kann.

4. Aufsatzgerät nach Anspruch 3, **dadurch gekennzeichnet, dass** die Einstellung von Frequenz und Amplitude des Ausgangssignals über Steuersoftware oder ein Verarbeitungssystem (20) in dem Aufsatzgerät erfolgt.

5. Aufsatzgerät (16) für den Einsatz mit einem Fernsehapparat (4), wobei das genannte Aufsatzgerät wenigstens eine Komponente (6; 14), die so eingestellt ist, dass sie mit einer Frequenz oder einem Frequenzbereich arbeitet, und einen HF-TV-Modulator (2; 18) aufweist, der so eingestellt ist, dass er mit einer/einem bestimmten Frequenz oder Frequenzbereich arbeitet, **dadurch gekennzeichnet, dass** der HF-TV-Modulator die Aufgabe hat, ein die Frequenzeinstellung anzeigendes Referenzsignal zu erzeugen, wobei sich das Steuermittel (20) für das Aufsatzgerät auf das genannte Signal bezieht, um die wenigstens eine Komponente so einzustellen, dass sie mit der/dem genannten Frequenz oder Frequenzbereich arbeitet.

6. Aufsatzgerät nach Anspruch 5, **dadurch gekennzeichnet, dass** sich das Steuermittel (20) in Zeitintervallen auf ein Signal von dem HF-TV-Modulator bezieht.

7. Aufsatzgerät nach Anspruch 6, **dadurch gekennzeichnet, dass** in vorbestimmten Zeitintervallen während der Benutzung des Aufsatzgerätes auf den HF-TV-Modulator Bezug genommen wird.

8. Aufsatzgerät nach Anspruch 6, **dadurch gekennzeichnet, dass** nach einem Funktions- oder Kanalwechsel des Aufsatzgerätes auf den HF-TV-Modulator Bezug genommen wird.

9. Aufsatzgerät nach einem der vorherigen Ansprüche, **dadurch gekennzeichnet, dass** dieses einen Speicher beinhaltet, in dem Informationen über die Ergebnisse einer vorbestimmten Zahl von früheren Bezugnahmen auf das HF-TV-Modulator-Referenzsignal gespeichert sind.

10. Aufsatzgerät nach Anspruch 9, **dadurch gekennzeichnet, dass** auf die in dem Speicher gehaltenen Ergebnisse in Zeitintervallen zusätzlich zu oder anstelle von Bezugnahmen auf das HF-TV-Modulatorsignal Bezug genommen wird.

11. Aufsatzgerät nach Anspruch 5, **dadurch gekennzeichnet, dass** der HF-TV-Modulator als modulierte Quelle verwendet wird, um die wenigstens eine in dem Aufsatzgerät enthaltene Komponente zum Empfangen und Verarbeiten von digitalen Daten zu kalibrieren.

12. Aufsatzgerät nach Anspruch 11, **dadurch gekennzeichnet, dass** der HF-TV-Modulator als QPSK/QAM-Modulatorgerät verwendet wird.

## Revendications

1. Dispositif décodeur (16) servant à traiter les données numériques reçues en vue d'un affichage sur un téléviseur (4) raccordé à celui-ci, ledit dispositif décodeur incluant au moins un composant (6 ; 14) qui doit être réglé sur une fréquence ou une gamme de fréquences spécifique pour fonctionner et comprenant en outre un modulateur de télévision (2 ; 18) radioélectrique, ledit modulateur générant un signal à une fréquence connue, et **caractérisé en ce que** ledit composant est automatiquement réglable à la fréquence ou à la gamme de fréquences spécifique requise en faisant référence au signal du modulateur de télévision radioélectrique, qui est indicatif du réglage de fréquence de celui-ci.

2. Dispositif décodeur, selon la revendication 1, **caractérisé en ce que** le modulateur de télévision radioélectrique est utilisé dans le dispositif décodeur en tant que dispositif générateur de signaux de télévision radioélectrique.

3. Dispositif décodeur, selon la revendication 2, **caractérisé en ce que** le modulateur de télévision radioélectrique incorpore un circuit d'oscillateur à boucle à phase asservie (12) et est capable d'effectuer un réglage de l'amplitude et de la fréquence du signal de sortie.

4. Dispositif décodeur, selon la revendication 3, **caractérisé en ce que** le réglage de l'amplitude et de la fréquence du signal de sortie est effectué par l'intermédiaire d'un logiciel de contrôle ou d'un système de traitement (20) à l'intérieur du dispositif décodeur.

5. Dispositif décodeur (16) destiné à être utilisé avec un téléviseur (4), ledit dispositif décodeur comprenant au moins un composant (6 ; 14) qui est réglé pour fonctionner à une certaine fréquence ou gamme de fréquences, et un modulateur de télévision radioélectrique (2 ; 18) qui est réglé pour fonctionner à une fréquence ou gamme de fréquences spécifique, et **caractérisé en ce que** ledit modulateur de télévision radioélectrique est exploité de façon à générer un signal de référence indicatif du réglage de fréquence, ledit signal étant utilisé comme référence par le moyen de contrôle (20) pour le dispositif décodeur afin de régler le au moins un composant pour fonctionner à ladite fréquence ou gamme de fréquences.

6. Dispositif décodeur, selon la revendication 5, **caractérisé en ce que** le moyen de contrôle (20) se réfère à un signal provenant du modulateur de télévision radioélectrique à certains intervalles de temps.

7. Dispositif décodeur, selon la revendication 6, **caractérisé en ce que** référence est faite au modulateur de télévision radioélectrique à des intervalles de temps prédéterminés pendant l'utilisation du dispositif décodeur.

8. Dispositif décodeur, selon la revendication 6, **caractérisé en ce que** référence est faite au modulateur de télévision radioélectrique lors d'un changement de fonction ou de canal du dispositif décodeur.

9. Dispositif décodeur, selon l'une quelconque des revendications précédentes, **caractérisé en ce que** celui-ci inclut une mémoire dans laquelle sont enregistrées des informations relatives aux résultats d'un nombre prédéterminé de références précédentes qui ont été faites au signal de référence du modulateur de télévision radioélectrique.

10. Dispositif décodeur, selon la revendication 9, **caractérisé en ce que** référence est faite aux résultats conservés dans la mémoire à des intervalles de temps, en plus de, ou au lieu de la référence faite au signal du modulateur de télévision radioélectrique.

11. Dispositif décodeur, selon la revendication 5, **caractérisé en ce que** le modulateur de télévision radioélectrique est utilisé en tant que source modulée pour calibrer le au moins un composant inclus dans le dispositif décodeur pour la réception et le traitement de données numériques.

12. Boîtier décodeur, selon la revendication 11, **caractérisé en ce que** le modulateur de télévision radioélectrique est utilisé en tant que dispositif modulateur QPSK / QAM.
